# EUROPEAN PATENT APPLICATION

(11) **EP 2 254 172 A2**
(43) Date of publication of application: **24.11.2010**
(21) Application number: 10162679.4
(22) Date of filing: 12.05.2010
(51) Int. Cl.: H01L 51/42, H01L 51/44

(54) **Solar cell with enhanced efficiency**

(30) Priority: 19.05.2009 US 468755
(71) Applicant: Honeywell International Inc., Morristown, NJ 07962 (US)
(72) Inventor: Zheng, Zhi, 200030, Shanghai Shanghai (CN); Wang, Marilyn, Pudong New Area Shanghai 201203 (CN); Zhao, Linan, 201204, Pudong New Area Shanghai (CN)
(74) Representative: Buckley, Guy Julian

(57) **Abstract**

Solar cells (10) and methods for manufacturing solar cells (10) are disclosed. An example solar cell (10) may include a substrate (12), which in some cases may act as an electrode (16), a nano-pillar array (18) coupled relative to the substrate (12), an active layer (20) provided on the nano-pillar array (18), and an electrode (16) electrically coupled to the active layer (20). In some cases, the active layer (20) may include a photoactive polymer.

## Description

### Technical Field

The disclosure relates generally to solar cells. More particularly, the disclosure relates to solar cells with enhanced efficiency and methods for manufacturing the same.

### Background

A wide variety of solar cells have been developed for converting light into electricity. Of the known solar cells, each has certain advantages and disadvantages. There is an ongoing need to provide alternative solar cells with enhanced efficiency, as well as methods for manufacturing solar cells.

### Summary

The disclosure relates generally to solar cells with enhanced efficiency, and methods for manufacturing solar cells. An illustrative solar cell may include a substrate. A nano-pillar array may be coupled relative to the substrate. In some cases, the substrate or some intervening layer, if present, may act as a first electrode for the solar cell. An active layer may be disposed on the nano-pillar array. The active layer may include a polymer, but this is not required. In some cases, the active layer may include an interconnected network of a photoactive material and an electron conductor material, such as an interconnected network of poly-3-hexylthiophen (P3HT) and [6,6]-phenyl-C61-butyric acid methyl ester (PCBM). A second electrode may be electrically coupled to the active layer.

Another illustrative solar cell may include a substrate, with an imprinted layer coupled relative to the substrate. In some cases, a first electrode is interposed between the substrate and the imprinted layer, but this is not required such as when the substrate acts as the first electrode. The imprinted layer may be suitable for accepting excitons from an active layer of the solar cell. In some cases, the imprinted layer may include polyimide, poly(3,4-ethylenedioxy-thiophene) poly(styrenesulfonate) (PEDOT:PSS), or any other suitable material. In some cases, the imprinted layer may be nano-imprinted with a nano-pillar array, but other patterns are also contemplated. An active layer may be disposed on the imprinted layer, and in some cases, interposed between the pillars of the nano-pillar array. A second electrode may be electrically coupled to the active layer.

An example method for manufacturing a solar cell may include providing a substrate that includes an imprintable layer. In some cases, a first electrode layer may be interposed between the substrate and the imprintable layer, but this is not required in all embodiments. The imprintable layer may be suitable for accepting excitons from an active layer of the solar cell. In some cases, the imprintable layer may be, for example, polyimide, poly(3,4-ethylenedioxythiophene) poly(styrenesulfonate) (PEDOT:PSS), or any other suitable material. A stamp may be provided that includes a defined pattern suitable for imprinting. In some cases, the pattern may include an array of nano-pits. The stamp may be used to imprint the imprintable layer to define a pattern in the imprintable layer, such as a nano-pillar array pattern. An active layer may be disposed on the imprinted layer, and in some cases, interposed between the pillars of the nano-pillar array. The active layer may include a polymer, but this is not required. In some cases, the active layer may include an interconnected network of a photoactive material and an electron conductor material, such as an interconnected network of poly-3-hexylthiophen (P3HT) and [6,6]-phenyl-C61-butyric acid methyl ester (PCBM). A second electrode may be provided on the active layer.

The above summary is not intended to describe each disclosed embodiment or every implementation of the present invention. The Figures and Description which follow more particularly exemplify certain illustrative embodiments.

### Brief Description of the Drawings

The invention may be more completely understood in consideration of the following detailed description of various embodiments of the invention in connection with the accompanying drawing, in which:

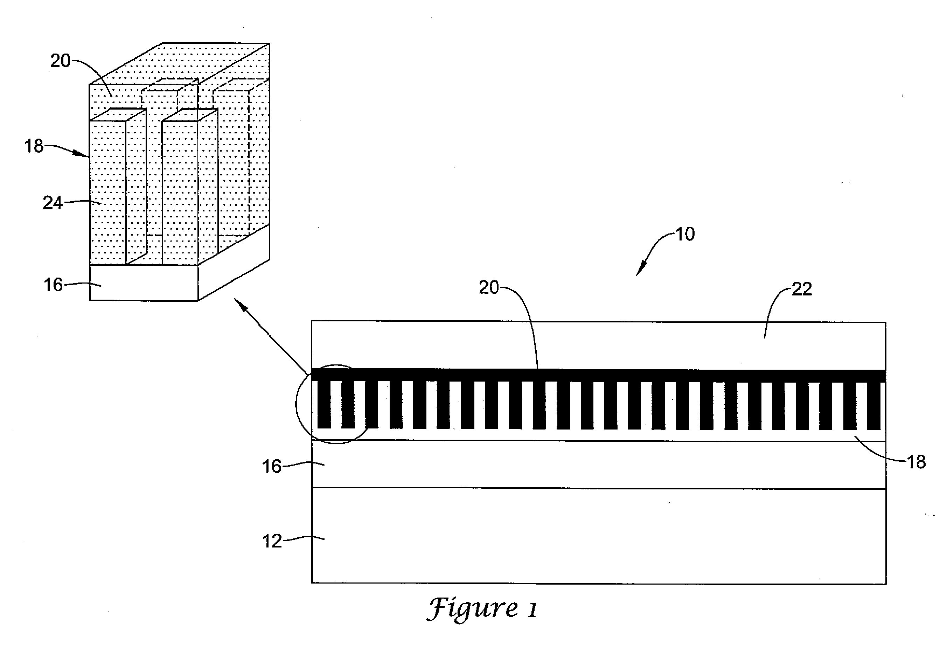

Figure 1 is a schematic cross-sectional side view of an illustrative solar cell.

While the invention is amenable to various modifications and alternative forms, specifics thereof have been shown by way of example in the drawing and will be described in detail. It should be understood, however, that the intention is not to limit the invention to the particular embodiments described. On the contrary, the intention is to cover all modifications, equivalents, and alternatives falling within the spirit and scope of the invention.

### Description

For the following defined terms, these definitions shall be applied, unless a different definition is given in the claims or elsewhere in this specification.

All numeric values are herein assumed to be modified by the term "about," whether or not explicitly indicated. The term "about" generally refers to a range of numbers that one of skill in the art would consider equivalent to the recited value (i.e., having the same function or result). In many instances, the terms "about" may include numbers that are rounded to the nearest significant figure.

The recitation of numerical ranges by endpoints includes all numbers within that range (e.g. 1 to 5 includes 1, 1.5, 2, 2.75, 3, 3.80, 4, and 5).

As used in this specification and the appended claims, the singular forms "a", "an", and "the" include plural referents unless the content clearly dictates otherwise. As used in this specification and the appended claims, the term "or" is generally employed in its sense including "and/or" unless the content clearly dictates otherwise.

The following description should be read with reference to the drawing. The drawing, which is not necessarily to scale, depict an illustrative embodiment and is not intended to limit the scope of the invention.

A wide variety of solar cells (which also may be known as photovoltaics and/or photovoltaic cells) have been developed for converting sunlight into electricity. Some example solar cells include a layer of crystalline silicon. Second and third generation solar cells often utilize a thin film of photovoltaic material (e.g., a "thin" film) deposited or otherwise provided on a substrate. These solar cells may be categorized according to the photovoltaic material deposited. For example, inorganic thin-film photovoltaics may include a thin film of amorphous silicon, microcrystalline silicon, CdS, CdTe, Cu₂S, copper indium diselenide (CIS), copper indium gallium diselenide (CIGS), etc. Organic thin-film photovoltaics may include a thin film of a polymer or polymers, bulk heterojunctions, ordered heterojunctions, a fullerence, a polymer/fullerence blend, photosynthetic materials, etc. These are only examples.

Efficiency may play an important role in the design and production of photovoltaics. One factor that may correlate to efficiency is the active layer thickness. A thicker active layer is typically able to absorb more light. This may desirably improve efficiency of the cell. However, thicker active layers often lose more charges due to higher internal resistance and/or increased recombination, which reduces efficiency. Thinner active layers may have less internal resistance and/or less recombination, but typically do not absorb light as effectively as thicker active layers.

The solar cells disclosed herein are designed to be more efficient by, for example, increasing the light absorbing ability of the active layer while reducing internal resistance and/or recombination. The methods for manufacturing photovoltaics and/or photovoltaic cells disclosed herein are aimed at producing more efficient photovoltaics at a lower cost.

At least some of the solar cells disclosed herein utilize an active layer that includes a polymer or polymers. For example, as least some of the solar cells disclosed herein include an active layer that includes a bulk heterojunction (BHJ) using conductive polymers. Solar cells that include a BHJ based on conductive polymers may be desirable for a number of reasons. For example, the costs for manufacturing a BHJ based on conductive polymers may be lower than the costs of manufacturing active layers of other types of solar cells. This may be due to the lower cost associated with the materials used to make such a BHJ (e.g., polymers) solar cell, as well as possible use of roll-to-roll and/ or other efficient manufacturing techniques.

Figure 1 is a schematic cross-sectional side view of an illustrative solar cell 10. In the illustrative embodiment, solar cell 10 include a substrate 12, with a first electrode (e.g., a cathode or positive electrode) 16 coupled relative to or otherwise disposed on substrate 12. A layer of material 18 may be electrically coupled to or otherwise disposed on electrode 16. The layer of material 18 may be formed from a material that is suitable for accepting excitons from active layer 20 of the solar cell 10. The layer of material 18 may include or be formed so as to take the form of a structured pattern or array, such as a nano-pillar array 18. An active layer 20 may be coupled to or otherwise be disposed over and "fill in" the structured pattern or array in layer 18. Solar cell 10 may also include a second electrode 22 (e.g., an anode or negative electrode) that is electrically coupled to active layer 20.

Substrate 12, when provided, may be made from a number of different materials including polymers, glass, and/or transparent materials. In one example, substrate 12 may include polyethylene terephthalate, polyimide, low-iron glass, or any other suitable material, or combination of suitable material. The first electrode 16 may include, fluorine-doped tin oxide, indium tin oxide, Al-doped zinc oxide, any other suitable conductive inorganic element or compound, conductive polymer, and other electrically conductive material, or any other suitable material. In some cases, the first electrode 16 may be considered the substrate. In some embodiments, solar cell 10 may lack substrate 12 and, instead, may rely on another structure to form a base layer, if desired.

Layer 18 may be an imprintable layer. In one example, layer 18 may include a material suitable for imprinting a pattern in the layer 18, such as a polymer. When a polymer is used, it is contemplated that a variety of different polymers may be suitable including, for example, polyimide, poly(3,4-ethylenedioxythiophene) poly(styrenesulfonate) (PEDOT:PSS), or any other suitable polymer or polymer combination, as desired. In some cases, layer 18 may have an energy band gap relative to the active layer 20 that is suitable for accepting excitons (e.g. holes) from the active layer 20. In some cases, layer 18 may be nano-imprinted with a nano-pillar array.

In an illustrative embodiment, active layer 20 may include one or more polymers or polymer layers. In one example, active layer 20 may include an interpenetrating network of electron donor and electron acceptor polymers. In at least some embodiments, active layer 20 may include an interpenetrating network of poly-3-hexylthiophen (P3HT) and [6,6]-phenyl-C61-butyric acid methyl ester (PCBM). It is contemplated that other materials may be used, as desired. P3HT is a photoactive polymer. Consequently, the P3HT material may absorb light and generate electron-hole pairs (excitons). While not being bound by theory, it is believed that as light is absorbed by active layer 20, an exciton is generated that diffuses to a nearby P3HT/PCBM interface within the active layer 20. The electrons may then be injected into the PCBM, which may have an energy band gap relative to P3HT so as to readily accept electrons from the P3HT material. The electrons may then be transported along the PCBM chain to the second electrode 22. The holes may be transported within the P3HT to a nearby pillar of, for example, a nano-pillar array in layer 18 and ultimately to the first electrode 16. As indicated above, layer 18 may have an energy band gap relative to the active layer 20 that is suitable for accepting excitons (e.g. holes) from the active layer 20.

The thickness of the active layer can have a significant effect on the efficiency of a solar cell. The pattern in layer 18 may decrease the effective thickness of the active layer 20, which may increase the efficiency of the solar cell. As indicated above, and while not limited to such, the pattern in layer 18 may be a nano-pillar array that includes a plurality of nano-pillars or projections 24 that extend upward. In an illustrative embodiment, nano-pillars 24 may have a width on the order of about 40-60nm, or about 50nm, and a spacing on the order of 10-80nm, or about 25nm. In some embodiments, nano-pillars 24 may have a substantially squared shape as shown so that the width in uniform in perpendicular directions. In other embodiments, nano-pillars 24 may be cylindrical in shape and, thus, may have a uniform width in all directions. However, it is contemplated that the nano-pillars may have any suitable shape including honeycomb shaped, star shaped, or any other shape, as desired. The nano-pillars 24 may be arranged so that adjacent nano-pillars 24 are spaced so as to form wells or channels therebetween. In some cases, the height of the nano-pillars 24 relative to their width may result in a relatively large aspect ratio, but this is not required. For example, the height of the nano-pillars 24 may be about 200-400nm, or about 250nm, which may result in about a 5:1 aspect ratio or more. It is contemplated that active layer 20 may be provided in the wells or channels between the nano-pillars 24, as shown. That is, the active layer 20 may fill the forest of nano-pillars 24. In some cases, the active layer 20 may be spin coated on the nano-pillars 24 to help fill in the wells and channels.

In general, the distance between adjacent nano-pillars 24 may be configured so as to improve the efficiency of the solar cell 10. For example, the distance between adjacent nano-pillars 24 may be set to about 10-80nm or less, or set to about 25nm or less. For example, with a pattern of square nano-pillars 24 spaced at 25nm, the furthest distance an exciton must travel within the active layer to an adjacent nano-pillar 24 is about 35nm. This travel distance can define the worst case "effective" thickness of the active layer 20. Note, in this illustrative embodiment, many of the excitons (e.g. holes) may travel laterally though the active layer to an adjacent nano-pillar 24, rather than vertically down to layer 18. In comparison, typical solar cells that utilize a BHJ may have a planar active layer with a thickness of about 100-200nm. When so provided, the worst case "effective" thickness of such an active layer may be 100-200nm. As can be seen, the effective thickness of the active layer 20 in solar cell 10 may be considerably reduced, which may help increase the efficiency of solar cells 10 by reducing internal resistance and/or recombination within the active layer 20.

While nano-pillars 24 are shown in Figure 1, it is contemplated that other arrangements or patterns may be used. In general, the structural arrangement of the pattern in layer 18 may be configured to produce a reduced effective thickness of the active layer 20 relative to a simple planar surface, and may include one or more projections and/or impressions, be textured, have surface features and/or other irregularities, or have other non-planar features, as desired.

It is also noted that the pattern in layer 18 may produce light scattering within the active layer 20 in solar cell 10. Because of this light scattering, more light (photons) may be absorbed by active layer 20. To help increase the light scatter and corresponding absorption of light in the active layer 20, it is contemplated that the height of the pattern in layer 18 relative to the width of the patterned elements may produce a relatively large aspect ratio (e.g. 2:1, 5:1, 10:1 or more). As mentioned above, the aspect ratio of the nano-pillars 24 may be about 5:1, but this is only an example.

An example method for manufacturing solar cell 10 may include providing substrate 12 including a layer 18 that will be imprinted with a pattern. In some cases, a first electrode layer 16(e.g. ITO) may be provided between substrate 12 and layer 18. In any event, a pattern may be imprinted or otherwise formed in layer 18. Alternatively, the layer 18 may be imprinted and then subsequently attached to a substrate 12 or the first electrode layer 16. In some cases, the substrate 12 may not be used. Forming the pattern in layer 18 may include any of a variety of different methods including, for example, hot embossing, soft lithography, micro-contact imprinting, ultraviolet lithographical imprinting, and the like, or using any other suitable method as desired. In one non-limiting example, a silicon wafer with an array of nano-pillars (e.g., about 50nm wide and about 250nm high) may be formed using a suitable technique such as e-beam lithography. A stamp may be formed by casting (e.g. spin coating) a stamp material (e.g., polydimethylsiloxane) onto the wafer and curing the material to form a stamp having an array of nano-pits (e.g., depressions that form the mirror image or inverse of the nano-pillars 24 on the wafer). Layer 18 may be spin-coated onto substrate 12 or the first electrode layer 16 so as to have a suitable thickness (e.g., about 300nm). The stamp may then be used to imprint layer 18 to form the nano-pillars 24 array.

Active layer 20 may be disposed on patterned layer 18 using any suitable method. In one example, the materials for active layer 20 (e.g., P3HT/PCBM) may be mixed in a suitable solvent and spin-coated onto patterned layer 18. The spin-coating process may help distribute the active layer 20 throughout the pattern on layer 18, e.g. filling the spaces between nano-pillars 24. The second electrode 22, which may be aluminum or any other suitable material, may be provided over active layer 20 using any suitable method such as e-beam evaporation or sputtering. Such a method may be easily scaled-up, which may make manufacturing of solar cells like solar cell 10 more cost-effective for a variety of applications including applications that use large quantities or sheets of solar cells 10.

It should be understood that this disclosure is, in many respects, only illustrative. Changes may be made in details, particularly in matters of shape, size, and arrangement of steps without exceeding the scope of the invention. The invention's scope, of course, is defined in the language in which the appended claims are expressed.

## Claims

1. A solar cell (10), comprising:
a substrate (12);
a nano-pillar array (18) coupled to the substrate (12);
an active layer (20) disposed on the nano-pillar array (18), the active layer (20) including a polymer; and
an electrode (16) electrically coupled to the active layer (20).

2. The solar cell (10) of claim 1, wherein the nano-pillar array (18) includes poly(3,4-ethylenedioxythiophene) poly(styrenesulfonate).

3. The solar cell (10) of any one of claims 1-2, wherein the active layer (20) includes an interconnected network of poly-3-hexylthiophen and [6,6]-phenyl-C61-butyric acid methyl ester.

4. A solar cell (10), comprising:
a substrate (12);
an imprinted layer (18) fixed relative to the substrate (12), the imprinted layer (18) including poly(3,4-ethylenedioxythiophene) poly(styrenesulfonate);
an active layer (20) disposed on imprinted layer (18); and
an electrode (16) electrically coupled to the active layer (20).

5. The solar cell (10) of claim 4, wherein the substrate (12) includes one or more of glass, indium tin oxide glass, fluorine-doped tin oxide glass, Al-doped zinc oxide glass, polyethylene terephthalate, indium tin oxide covered polyethylene terephthalate, fluorine-doped tin oxide covered polyethylene terephthalate, Al-doped zinc oxide covered polyethylene terephthalate, polyimide, indium tin oxide covered polyimide, fluorine-doped tin oxide covered polyimide, and Al-doped zinc oxide covered polyimide.

6. The solar cell (10) of any one of claims 4-5, wherein the active layer (20) includes a polymer.

7. The solar cell (10) of any one of claims 4-6, wherein the active layer (20) includes an interconnected network of poly-3-hexylthiophen and [6,6]-phenyl-C61-butyric acid methyl ester.

8. The solar cell (10) of any one of claims 4-7, wherein the imprinted layer (18) includes a plurality of nano-pillars (24) imprinted thereon.

9. The solar cell (10) of claim 8, wherein the maximum spacing between adjacent nano-pillars (24) is about 50 nanometers or less.

10. A method for manufacturing a solar cell (10), the method comprising:
providing a layer (18) ofpoly(3,4-ethylenedioxythiophene) poly(styrenesulfonate);
providing a stamp that includes an array of nano-pits;
imprinting the layer (18) ofpoly(3,4-ethylenedioxythiophene) poly(styrenesulfonate) to define a plurality of nano-pillars (24) in the layer (18) of poly(3,4-ethylenedioxythiophene) poly(styrenesulfonate); and
coating the nano-pillar array (18) with an active polymer layer (18) that includes a photoactive material (18).
